# EUROPEAN PATENT APPLICATION

(11) **EP 4 492 692 A1**
(43) Date of publication of application: **15.01.2025**
(21) Application number: 24185285.4
(22) Date of filing: 28.06.2024
(51) Int. Cl.: H04B 1/04

(54) **RF CIRCUIT AND OPERATION METHOD THEREFOR**

(30) Priority: 12.07.2023 KR 20230090688; 24.10.2023 KR 20230142678
(71) Applicant: Samsung Electronics Co., Ltd., Suwon-si, Gyeonggi-do 16677 (KR)
(72) Inventor: YOON, Kyunghyun, Suwon-si, Gyeonggi-do 16677 (KR); BAE, Jeongyeol, Suwon-si, Gyeonggi-do 16677 (KR); LEE, Jongsoo, Suwon-si, Gyeonggi-do 16677 (KR); YOO, Sangmin, Suwon-si, Gyeonggi-do 16677 (KR)
(74) Representative: Kuhnen & Wacker Patent- und Rechtsanwaltsbüro PartG mbB

(57) **Abstract**

Disclosed is an RF circuit (100), which includes a mixer (110) that converts a first signal (S1) into a second signal (S2) using a local oscillator, LO, signal (LO), an amplifier (140) that amplifies the second signal (S2), and an impedance tuner circuit (120) connected between the mixer (110) and an input terminal of the amplifier (140), and that adjusts a conversion gain of the mixer (110) by presenting a variable impedance.

## Description

### Technical Field

Embodiments of the present disclosure described herein relate to a radio frequency (RF) circuit and an operation method therefor.

### Discussion of Related Art

Various dynamic ranges may be required with respect to an RF transmission chain (Tx chain). For example, communication protocols such as the 3rd Generation Partnership Project (3GPP) may require a dynamic range of about 80 dB or more with respect to a cellular transmission chain. If so, each of several blocks included in the transmission chain may be designed to secure the required dynamic range through gain control.

Meanwhile, a circuit structure with a wider gain control range and a structure for performance optimization may be in a trade-off relationship. Thus, to expand the gain control range of the entire transmission chain without degrading the performance of each block included in the transmission chain, it may be required to optimize the performance of each block and at the same time design the blocks to share the burden of the gain control with each other.

### SUMMARY

Embodiments of the present disclosure provide an RF circuit capable of controlling a conversion gain of a mixer and a method of operating the same. The conversion gain control of various embodiments may result in an expanded gain control range for the RF circuit.

According to an embodiment of the present disclosure, an RF circuit includes a mixer that converts a first signal into a second signal using a local oscillator (LO) signal, an amplifier that amplifies the second signal, and an impedance tuner circuit connected between the mixer and an input terminal of the amplifier and that adjusts a conversion gain of the mixer by presenting a variable impedance.

According to an embodiment of the present disclosure, a wireless communication device includes an RF integrated circuit (RFIC) that up-converts a baseband signal to output an RF signal, and a power amplifier that amplifies the RF signal. The RFIC includes a mixer that converts the baseband signal into the RF signal using an LO signal, an amplifier that amplifies the RF signal, and an impedance tuner circuit, connected between the mixer and an input terminal of the amplifier, that controls a conversion gain of the mixer by presenting a variable impedance.

According to an embodiment of the present disclosure, a method of operating an RF circuit includes adjusting a conversion gain of a mixer by varying an impedance of an impedance tuner circuit, converting a first signal into a second signal using an LO signal applied to the mixer, and amplifying the second signal.

### BRIEF DESCRIPTION OF THE FIGURES

The above and other aspects and features of the present disclosure will become apparent by describing in detail embodiments thereof with reference to the accompanying drawings.
FIG. 1 illustrates a Radio Frequency (RF) circuit according to some embodiments.
FIGS. 2 and 3 illustrate an operation of the RF circuit of FIG. 1, according to some embodiments.
FIGS. 4 and 5 illustrate RF band characteristics according to a conversion gain control, according to some embodiments.
FIG. 6 illustrates an RF circuit when an impedance tuner circuit is turned off, according to some embodiments.
FIGS. 7 and 8 illustrate an RF circuit when an impedance tuner circuit is turned on, according to some embodiments.
FIG. 9 illustrates a relationship between a load impedance and a conversion gain, according to some embodiments.
FIG. 10 illustrates a relationship between a gain index and an output of an amplifier, according to some embodiments.
FIG. 11 illustrates a layout of an RF circuit, according to some embodiments.
FIG. 12 is a flowchart illustrating a method of operating an RF circuit according to some embodiments.
FIG. 13 is a flowchart illustrating a method for adjusting an impedance of an RF circuit, according to some embodiments.
FIG. 14 illustrates a wireless communication device according to some embodiments.
FIG. 15 illustrates an IoT (Internet of Things) device to which a wireless communication device is applied, according to some embodiments.
FIG. 16 illustrates a mobile terminal to which a wireless communication device is applied, according to some embodiments.

### DETAILED DESCRIPTION

Hereinafter, embodiments of the present disclosure will be described in detail and clearly to such an extent that an ordinary one in the art may readily implement embodiments of the present disclosure.

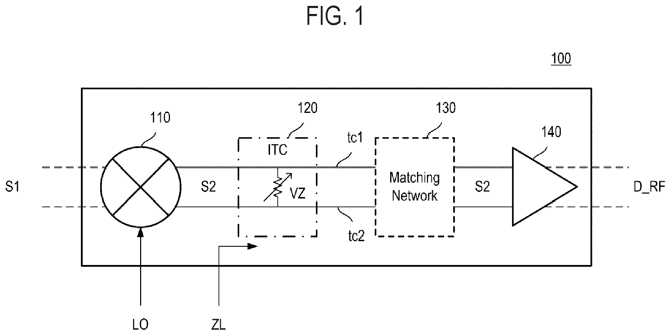

FIG. 1 illustrates a Radio Frequency (RF) circuit according to some embodiments.

Referring to FIG. 1, an RF circuit 100 may include a mixer 110, an impedance tuner circuit 120, and an amplifier 140. A matching network 130 may be additionally included according to some embodiments.

The mixer 110 may be configured to convert a first signal S1 into a second signal S2 using a local oscillator (LO) signal applied to the mixer 110. The LO signal LO may be provided by an oscillator (not illustrated) and may have a frequency for up-converting the frequency of the first signal S1 to the frequency of the second signal S2 in a higher frequency band. The mixer 110 may up-convert the first signal S1 into the second signal S2 in a higher frequency band by mixing the first signal S1 and the LO signal LO. For example, the first signal S1 may be a baseband signal with a baseband frequency, and the second signal S2 may be an RF signal with an RF frequency.

According to some embodiments, the mixer 110 may be implemented as an active mixer that utilizes a direct current (DC) power, or a passive mixer that does not utilize a DC input. The mixer 110 may be implemented as a differential mixer, or as a single-ended mixer. The mixer 110 may be implemented by using various circuit elements, including nonlinear elements such as transistors.

The mixer 110 may have a conversion gain. Accordingly, the second signal S2, which is the output of the mixer 110, may have power increased by the conversion gain from the first signal S1. For example, the conversion gain of the mixer 110 may be determined based on an "on resistance" of the transistor included in the mixer 110 and voltage distribution according to a load impedance ZL of the mixer 110. When the load impedance ZL of the mixer 110 has a fixed value (as in conventional RF circuits), it may be difficult to adjust the conversion gain.

The impedance tuner circuit 120 may be connected between the mixer 110 and an input terminal of the amplifier 140. The impedance tuner circuit 120 may be configured such that its own impedance may be varied. For example, the impedance tuner circuit 120 may have a variable impedance VZ which is connected between a first transmission line conductor tc1 and a second transmission line conductor tc2, which may be conductors of a transmission line or interconnect through which the second signal S2 is output from the mixer 110. The variable impedance VZ may be presented to the output of the mixer 110, such that the load impedance ZL of the mixer is based on a combination of the transmission line or interconnect impedance, the impedance VZ, and the impedance "looking into" the matching network 130. According to some embodiments, the variable impedance VZ of the impedance tuner circuit 120 may be implemented based on passive elements such as switchable resistors, capacitors, and inductors, thereby making it applicable to various matching networks 130. Additionally, the impedance tuner circuit 120 may be implemented to include one or more variable impedance circuits, each of which includes one or more passive elements.

By varying the impedance VZ, the impedance tuner circuit 120 may adjust the conversion gain of the mixer 110. To this end, when the impedance VZ of the impedance tuner circuit 120 varies, the load impedance ZL of the mixer 110 may also vary. In other words, the impedance tuner circuit 120 may vary the load impedance ZL of the mixer 110 by varying its impedance VZ. Ultimately, as the load impedance ZL of the mixer 110 varies due to the impedance tuner circuit 120, the conversion gain that is determined based on the load impedance ZL may also vary.

According to some embodiments, the impedance tuner circuit 120 may be configured to have a variable impedance VZ based on the output power of the RF circuit 100. Here, the impedance tuner circuit 120 may operate to have a switchable impedance VZ according to the desired output power of the RF circuit 100. For example, the impedance tuner circuit 120 may be controlled to be "turned off" when the RF circuit 100 operates in a high power mode in which its output power is greater than or equal to a first threshold. In this case, turning off the impedance tuner circuit 120 may mean that the impedance VZ of the impedance tuner circuit 120 is theoretically infinite (correspondingly, the admittance of the impedance tuner circuit 120 is "0"). In other words, the impedance tuner circuit 120 appears approximately nonexistent to the rest of the RF circuit 100. As a result, the load impedance ZL may be based on just a combination of the characteristic impedance of the transmission line or interconnect with conductors tc1 and tc2, and the impedance seen "looking into" the matching network 130 (if present) or the amplifier 140 (if the matching network 130 is omitted).

Thus, when the impedance tuner circuit 120 is turned off, the load impedance ZL of the mixer 110 will have the largest value when there is no change in other impedances included in the load impedance ZL. Accordingly, turning off the impedance tuner circuit 120 may maximize the conversion gain of the mixer 110.

Conversely, the impedance tuner circuit 120 may be turned on when the RF circuit 100 operates in a low power mode in which its output power is less than or equal to a second threshold. In this case, turning on the impedance tuner circuit 120 may mean that the impedance VZ of the impedance tuner circuit 120 has a specific value other than infinity.

When the impedance tuner circuit 120 is turned on, the load impedance ZL of the mixer 110 may have a lower impedance value than when the impedance tuner circuit 120 is turned off (assuming there is no change in other impedances included in the load impedance ZL). As the impedance presented by the impedance tuner circuit 120 is decreased, the load impedance ZL of the mixer 110 will also decrease. Accordingly, the conversion gain of the mixer 110 will decrease as the impedance tuner circuit 120 is turned on and the impedance is lowered.

As the conversion gain is adjusted through the impedance tuner circuit 120, the power of the second signal S2, which is the output signal of the mixer 110, will also change. When the impedance tuner circuit 120 is turned off, the conversion gain will be the highest, so the second signal S2 may have greater power. Conversely, when the impedance tuner circuit 120 is turned on and the impedance is lowered, the conversion gain will decrease, so the second signal S2 may have lower power. Adjusting the conversion gain of the mixer 110 through the impedance tuner circuit 120 may contribute to reducing the size of the leakage component of the amplifier 140, as will be described later.

The amplifier 140 may be configured to amplify the second signal S2. For example, the amplifier 140 may be a driver amplifier DA for amplifying the second signal S2 before a power amplifier PA. The amplifier 140 may output an amplified RF signal D_RF by amplifying the second signal S2 based on the amplifier gain, hereinafter referred to as "signal gain" (to distinguish the gain from "leakage gain" discussed below). To secure a dynamic range of the RF circuit 100, the amplifier 140 may have a gain control function. Considering that gain control is performed on the first signal S1 of the baseband corresponding to the previous stage of the amplifier 140, since the previous stage of the amplifier 140 has a more direct effect on a Signal-to-Noise Ratio (SNR), a wide gain control may be difficult in conventional RF circuits. Additionally, in conventional RF circuits, since an amount of leakage of the LO signal LO may change during the gain control in the previous stage of the amplifier 140, a DC Offset Cancellation (DCOC) calibration may need to be additionally performed each time gain control is performed. Accordingly, in embodiments of the present disclosure, the amplifier 140 may allow the RF circuit 100 to have a wider dynamic range and not require a separate DCOC calibration, by supporting the gain control.

In this case, in addition to the second signal S2, which is the signal for which amplification is desired, the amplifier 140 may also amplify unwanted leakage components due to parasitic components (or coupling paths) depending on the implementation of the amplifier 140. Hereinafter, separately from the signal gain for the desired signal, the gain for the leakage component will be referred to as a leakage gain. The leakage gain may have a fixed value depending on the design of the amplifier 140. For example, even though the input signal to the amplifier 140 or the signal gain of the amplifier 140 changes, the leakage gain may be fixed.

As the RF circuit 100 operates with lower output power to secure the dynamic range, the amplifier 140 may need to provide attenuation rather than gain to the input signal S2 to generate the amplified RF signal D_RF at the lower output power. To this end, to lower the output power of the RF circuit 100, the signal gain of the amplifier 140 may be decreased. In this case, the influence of the leakage component according to the leakage gain may be relatively increased (because the leakage gain may be fixed even when the signal gain is decreased). When the leakage component becomes a dominant component than the desired signal, the leakage component may act as a lower limit with respect to the dynamic range.

According to some embodiments described herein, the impedance tuner circuit 120 may be provided at the output of the mixer 110 to adjust the conversion gain of the mixer 110. When the conversion gain of the mixer 110 is reduced through the impedance tuner circuit 120, the size of the second signal S2 provided to the input terminal of the amplifier 140 may also be reduced. In such cases, reducing the conversion gain of the mixer 110 also reduces the leakage component applied to the input of the amplifier 140. Then, the leakage component output through the amplifier 140 with a fixed leakage gain may be relatively reduced. In other words, the amplifier 140 may output a reduced leakage component from the second signal S2 as the conversion gain decreases.

According to some embodiments, the amplifier 140 may adjust the signal gain through the gain control. In particular, the amplifier 140 may increase the signal gain to compensate for a decrease in conversion gain through the impedance tuner circuit 120. In detail, the amplifier 140 may increase the amplification gain. Accordingly, the amplifier 140 amplifies the second signal S2 according to the increased amplifier gain, and thus may still output the amplified RF signal D_RF having the desired output power despite the reduction in the conversion gain.

According to some embodiments, the RF circuit 100 may further include the matching network 130 connected between the impedance tuner circuit 120 and the input terminal of the amplifier 140. The matching network 130 may be configured to provide impedance matching between the mixer 110 and the amplifier 140. For example, the matching network 130 may be implemented based on an LC tank, a transformer, etc.

According to the above-described embodiments, the conversion gain of the mixer 110 may be adjusted through the impedance tuner circuit 120, and thus the gain of the RF circuit 100 may be adjusted. Therefore, according to some embodiments, a separate gain control function may not be required for the matching network 130. In this case, the matching network 130 may tune the load impedance ZL to an optimum value (e.g., the maximum), so that the RF circuit 100 may satisfy minimum current and maximum output power requirements when the RF circuit 100 operates with a higher gain.

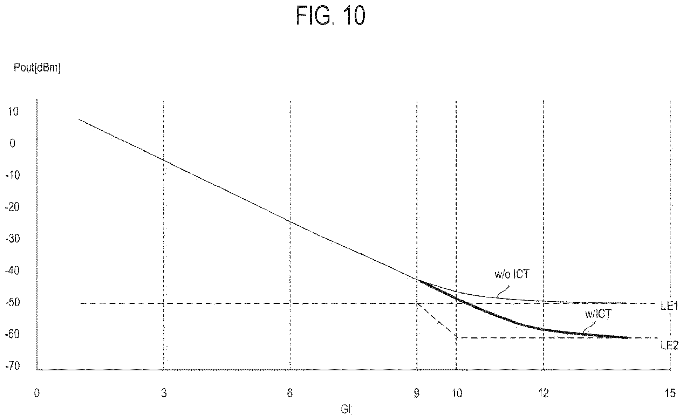

According to the above-described embodiments, the RF circuit 100 of the present disclosure may adjust the conversion gain of the mixer 110 by varying the load impedance ZL of the mixer 110 through the impedance tuner circuit 120. By adjusting the conversion gain of the mixer 110, embodiments of the present disclosure may lower the lower limit of the dynamic range by relatively reducing the leakage component of the amplifier 140 (as illustrated in FIG. 10, discussed later). Therefore, according to the present disclosure, the dynamic range of the RF circuit 100 may be increased.

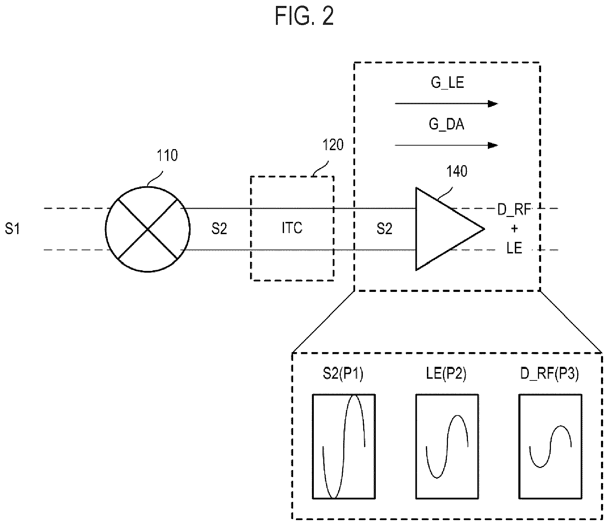

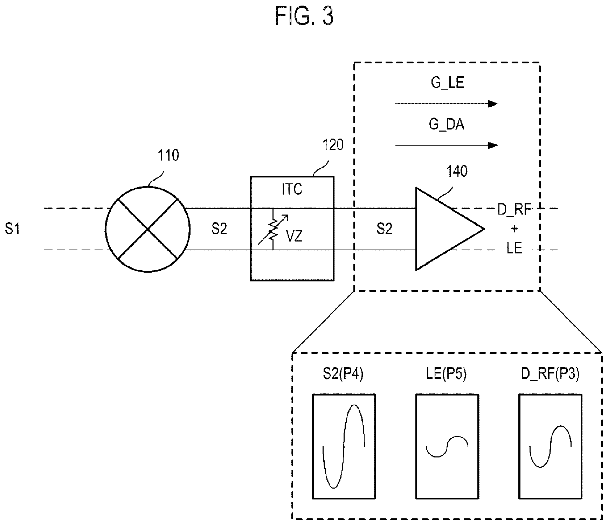

FIGS. 2 and 3 illustrate an operation of the RF circuit of FIG. 1, according to some embodiments.

Referring first to FIG. 2, when the impedance tuner circuit 120 may be turned off in certain situations, such as in the high power mode discussed above. In such cases, since the load impedance of the mixer 110 will be fixed, and the conversion gain of the mixer 110 will also have a fixed value.

When the conversion gain of the mixer 110 is not adjusted, and when the mixer 110 is a passive mixer, the second signal S2, which is an output signal of the mixer 110, will also have a fixed power, P1. Additionally, as described above, a leakage gain G_LE of the amplifier 140 will have a fixed value, resulting in a leakage component LE output from the amplifier 140 at a power P2 (which may be fixed when the conversion gain is at a maximum, even when the signal gain is adjusted). Accordingly, the amplified RF signal D_RF will have a power of P3, which is P1 multiplied by the signal gain G_DA. In this case, as illustrated, when the leakage component LE finally output through the amplifier 140 is greater than the amplified RF signal D_RF, which is the desired signal, the leakage component LE becomes a dominant component, and also may act as the lower limit of the dynamic range. Thus, the amplified RF signal D_RF may not have the desired (or intended) output power, but may be limited to the power of the leakage component LE during the low power mode. (Further explanation of this lower limit is described below in connection with FIG. 10)

The lower limit issue due to the leakage component LE described above may occur when the signal gain G_DA is less than the leakage gain G_LE as the output power required for the RF circuit 100 is lowered. In addition, in conventional RF circuits that lack the impedance tuner circuit 120, the conversion gain of the mixer 110 is not adjusted using a variable output impedance, and the size of the second signal S2 may not be adjusted, so the lower limit issue due to the leakage component LE may not be solved.

Next, referring to FIG. 3, when the impedance tuner circuit 120 is provided and turned on according to some embodiments, the conversion gain of the mixer 110 may be adjusted. For example, the impedance tuner circuit 120 may lower the conversion gain of the mixer 110, and accordingly, the second signal S2 may have a power of P4 that is lower than that of P1. Likewise, when the leakage gain G_LE is the same, the leakage component LE has the power of P5, which is less than that of P2 in FIG. 2. Ultimately, the size of the leakage component LE may be further reduced through conversion gain control.

Additionally, according to some embodiments, the amplifier 140 may further increase the signal gain G_DA to compensate for the reduced power of the second signal S2 through the conversion gain control. Accordingly, the amplified RF signal D_RF may be output to have the same power P3 (or a power level similar to P3) as illustrated in FIG. 2.

Ultimately, the impedance tuner circuit 120 according to the present disclosure may reduce the amplitude of the second signal S2 provided to the input terminal of the amplifier 140 by reducing the conversion gain of the mixer 110. In such cases, the leakage component LE output through the amplifier 140 with the fixed leakage gain G_LE may be relatively reduced from P2 to P5. As the leakage component LE becomes lower, the lower limit of the dynamic range also becomes lower, so the dynamic range may be secured. Additionally, the amplifier 140 amplifies the second signal S2 in the low power mode according to the increased amplifier gain, thereby outputting an amplified RF signal D_RF that still has the desired output power despite the reduction in the conversion gain.

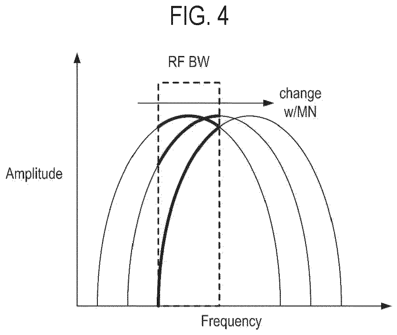

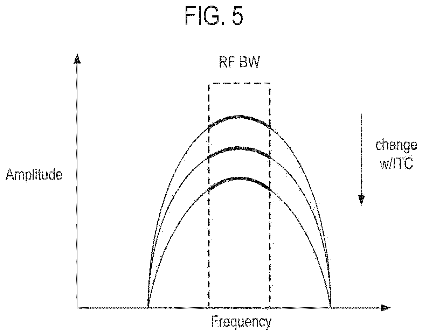

FIGS. 4 and 5 illustrate RF band characteristics according to a conversion gain control, according to some embodiments.

First, referring to FIG. 4, a case where the conversion gain of the mixer 110 is adjusted ("change w/MN") just through a tunable matching network 130 may be considered as an example. In the case of the tunable matching network 130, the conversion gain may be adjusted by changing the impedance. The operation of the matching network 130 that deviates from the impedance pre-tuned (matched) for the conversion gain control may be defined as a de-tuning (or a mismatched state). Through the de-tuning, it may be seen that the gain of the RF waveform is gradually adjusted within a required RF bandwidth RF BW. However, the de-tuning inevitably involves changing the matched frequency, so as the center frequency of the RF waveform becomes increasingly distorted, it may be seen that the band flatness of the RF waveform within the RF bandwidth RF BW also collapses.

Ultimately, when the conversion gain is adjusted through the tunable matching network 130, the required frequency may not be satisfied and the band flatness may also be broken.

Next, referring to FIG. 5, according to some embodiments, the matching network 130 may be fixed, but the conversion gain of the mixer 110 may be adjusted ("change w/ITC") through the impedance tuner circuit 120. In this case, it may be seen that the gain is adjusted while the RF waveform maintains the center frequency within the RF bandwidth RF BW. Therefore, according to the RF circuit of the present disclosure, required frequency specifications may be satisfied while maintaining the band flatness of the RF waveform. Additionally, the dynamic range may be wider due partly to the gain control.

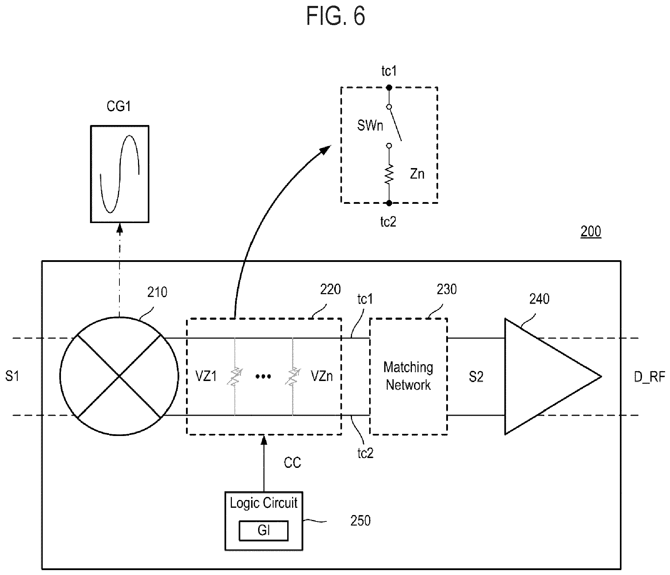

FIG. 6 illustrates an RF circuit 200 when an impedance tuner circuit 220 is turned off, according to some embodiments.

Referring to FIG. 6, the RF circuit 200 according to some embodiments may further include a logic circuit 250 for controlling the impedance tuner circuit 220. The logic circuit 250 may be configured to vary the impedance of the impedance tuner circuit 220 based on a gain index GI for the gain control of the RF circuit 200. The gain index GI may be defined as an index corresponding to the gain level required for the RF circuit 200. For example, as at least one of the impedance tuner circuit 220 and an amplifier 240 operates, the gain of the RF circuit 200 required at a specific gain index GI may be adjusted. There may be various situations in which the logic circuit 250 receives a command signal from an external source (not shown) to change the gain index. For instance, if the RF circuit 100 is part of a portable wireless device, the wireless device may be requested by a base station to lower its output power when a lower power signal would suffice for the communication.

The logic circuit 250 may control the impedance tuner circuit 220 (with a control signal CC) to have an impedance level sufficient to realize the overall RF circuit 100 gain corresponding to the specific gain index GI. For example, the impedance tuner circuit 220 may include one or more variable impedance circuits VZ1 to VZn as illustrated. Any of the impedance circuits, such as VZn, may include a switch, e.g., SWn, in series with a fixed impedance Zn, where the switch SWn is controlled by the control signal CC to open or close. The logic circuit 250 may control the impedance tuner circuit 220 to have an impedance level required at the specific gain index GI based on turning on/off one or more variable impedance circuits VZ 1 to VZn (e.g., by closing/opening a respective switch like SWn in each of the impedance circuits VZ1 to VZn). Additionally, the impedance tuner circuit 220 may stepwise adjust the conversion gain of a mixer 210 based on varying one or more variable impedance circuits VZ 1 to VZn under the control of the logic circuit 250.

When the entire impedance tuner circuit 220 is to be turned off at a specific gain index GI, the logic circuit 250 may turn off the impedance tuner circuit 220. For example, as the impedance tuner circuit 220 is turned off, the variable impedance circuits VZ1 to VZn may all be deactivated (i.e., the impedance of each variable impedance circuit may be infinite).

In such cases, the load impedance of the mixer 210 may have an optimized value (to achieve a maximum signal level of the signal S2) when there is no change in other impedances included in the load impedance. Accordingly, when the impedance tuner circuit 220 is turned off, a conversion gain CG1 of the mixer 210 may be maximized.

According to some embodiments, the logic circuit 250 may turn off the impedance tuner circuit 220 when the RF circuit 200 operates in a high power mode. In this case, the gain level corresponding to the gain index GI in the high power mode will be higher. For example, the logic circuit 250 may determine whether to operate in the high power mode based on the gain index GI. As the impedance tuner circuit 220 is turned off, the load impedance of the mixer 210 may increase, resulting in the mixer 210 having the maximized conversion gain CG1. Ultimately, the second signal S2 output to a matching network 230 and the amplifier 240 through the mixer 210 may satisfy a target output power in the high power mode.

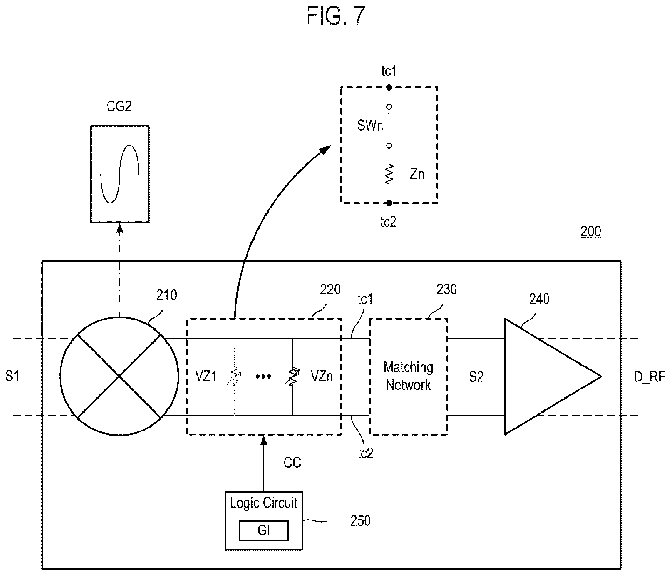

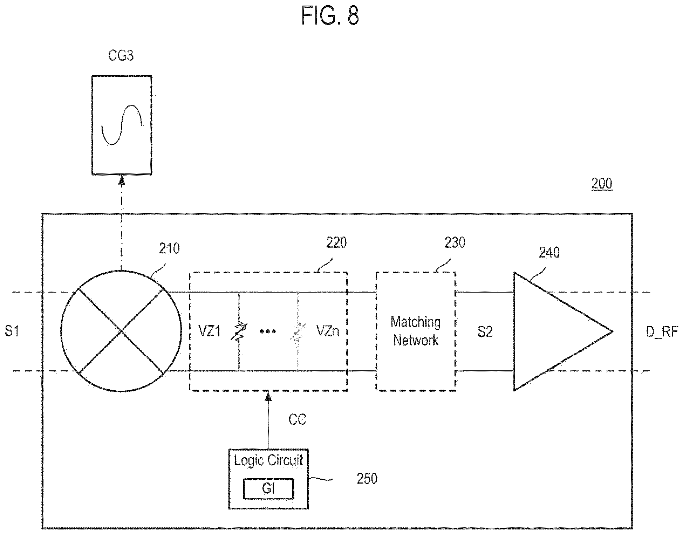

FIGS. 7 and 8 illustrate an RF circuit when an impedance tuner circuit is turned on, according to some embodiments.

Referring to FIGS. 7 and 8, when the impedance tuner circuit 220 is to be turned on at the specific gain index GI, the logic circuit 250 may turn on the impedance tuner circuit 220. The logic circuit 250 may reduce the conversion gain by turning on the impedance tuner circuit 220 at a k-th value of the gain index GI (where 'k' is a natural number). For example, as the impedance tuner circuit 220 is turned on, one or more variable impedance circuits VZ1 to VZn may be activated (i.e., the impedance of each variable impedance circuit may have a value other than infinity). In addition, when the impedance tuner circuit 220 is implemented in a differential structure, the conversion gain may be adjusted by adjusting the amount by which the differential output signals of the mixer 210 cancel each other as the impedance changes.

According to some embodiments, each of the one or more variable impedance circuits VZ1 to VZn may operate in a switchable manner and may have an array structure formed in parallel. One or more variable impedance circuits VZ1 to VZn may have variable impedances that are the same or different from each other. As one or more variable impedance circuits VZ1 to VZn are activated, the equivalent impedance VZ (see FIG. 1) of the impedance tuner circuit 220 may be adjusted. As the number of one or more variable impedance circuits VZ1 to VZn increases, or equivalent impedance value that may be combined according to one or more variable impedance circuits VZ1 to VZn increases, a finer conversion gain control may be possible.

When the impedance tuner circuit 220 is turned on, the impedance tuner circuit 220 may have an impedance that varies depending on the number of activated variable impedance circuits. For example, in the case of FIG. 7, since the n-th variable impedance circuit VZn is turned on, the impedance tuner circuit 220 may have an impedance Zn corresponding to the n-th variable impedance circuit VZn. For example, in the case of FIG. 8, since the first variable impedance circuit VZ 1 is turned on and the remaining impedance circuits are turned off, the impedance tuner circuit 220 may have an impedance Z1 corresponding to the first variable impedance circuit VZ1.

When Zn is greater than Z1, the load impedance in FIG. 7 will be greater than the load impedance in FIG. 8. Accordingly, a conversion gain CG2 in FIG. 7 will also be greater than a conversion gain CG3 in FIG. 8. Ultimately, the logic circuit 250 may adjust the conversion gain by varying the impedance of the impedance tuner circuit 220 according to a gain level corresponding to the gain index GI.

According to some embodiments, the logic circuit 250 may turn on the impedance tuner circuit 220 when the RF circuit 200 operates in a low power mode. In this case, the gain level corresponding to the gain index GI in the low power mode will be lower. For example, the logic circuit 250 may determine whether to operate in the low power mode based on the gain index GI. As the impedance tuner circuit 220 is turned on, the load impedance of the mixer 210 decreases, so the mixer 210 may have the conversion gain CG2 or CG3. In particular, depending on the output power required in the low power mode, the conversion gain may be adjusted in various ways. For example, the impedance tuner circuit 220 may activate one or more variable impedance circuits VZ1 to VZn to increase the impedance so that the mixer 210 has the higher conversion gain CG2. For example, the impedance tuner circuit 220 may activate one or more variable impedance circuits VZ1 to VZn to decrease the impedance so that the mixer 210 has the lower conversion gain CG3.

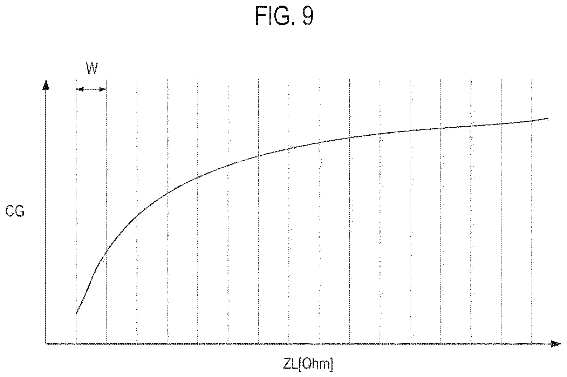

FIG. 9 illustrates a relationship between a load impedance and a conversion gain, according to some embodiments.

Referring to FIG. 9, according to the above-described embodiments, the impedance tuner circuit of the present disclosure may stepwise adjust the load impedance of the mixer by activating one or more variable impedance circuits. A horizontal axis of FIG. 9, in detail, an adjustment width W by which the load impedance is adjusted, may be determined depending on how finely the impedance tuner circuit may adjust the impedance. For example, as more variable impedance circuits included in the impedance tuner circuit are provided, the adjustment width W may be made more precise. Additionally, as illustrated, as the load impedance increases (i.e., as the impedance of the impedance tuner circuit increases), the conversion gain may increase.

FIG. 10 illustrates a relationship between a gain index and an output of an amplifier, according to some embodiments.

Referring to FIG. 10, according to a change in the gain index, the output power of the amplifier may vary with respect to cases where an impedance tuner circuit is provided ("w/ICT") and is not provided ("w/o ICT"), according to some embodiments. For example, assuming that the dynamic range required for the entire transmission path including the RF circuit is about 80dBm, and that a gain control of about 15dBm is possible in the power amplifier PA connected to the RF circuit, ultimately, it may be seen that the gain control of about 65dBm is required in the RF circuit. The amplifier may adjust the gain in units of a specific size every time the gain index changes by '1'. In Figure 10, it may be adjusted in units of about 6dBm. In addition, it is assumed in this example that the input of the amplifier is about -10dBm and that the fixed leakage gain due to the implementation of the amplifier is about -40dB.

Due to the leakage gain, in the case of w/o ICT, a first leakage component LE1 of about -50dBm may be output. This first leakage component LE1 acts as the low limit of the dynamic range, so it may be confirmed that the gain does not fall below the low limit despite adjusting the gain index. Then, in the case of w/o ICT, the dynamic range defined by the maximum and minimum values of output power is about 55dBm, so the gain control ability (about 65dB) required for the RF circuit is not satisfied.

In contrast, in the case of w/ICT, the output of the mixer, that is, the input of the amplifier, is reduced from about -10dBm to about -22dBm by lowering the conversion gain of the mixer through the impedance tuner circuit at a 10th of the gain index. Therefore, based on a fixed leakage gain (-40dB), a second leakage component LE2 for w/ICT may have a further reduced value of about -62dBm. In the case of w/ICT, the lower limit may be even lower.

Ultimately, in the case of the w/ICT example, the dynamic range is further improved to about 67dBm, so the gain control capability (about 65dB) required for the RF circuit may be met. By additionally securing the gain control capability of about 12dB in w/ICT, the burden of the dynamic range that the amplifier is responsible for may be reduced, optimized design of the amplifier is possible, and it may also be freed from limitations of the dynamic range due to the lower limit.

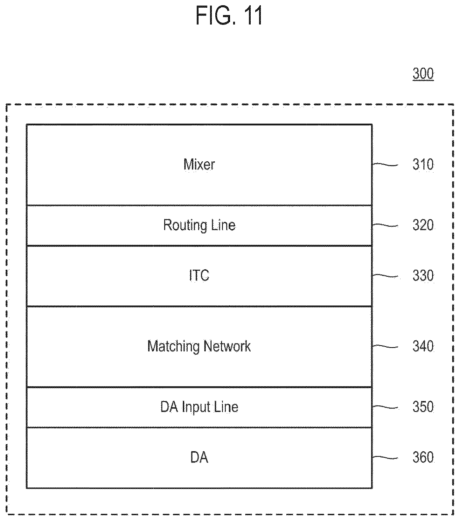

FIG. 11 illustrates a layout of an RF circuit, according to some embodiments.

Referring to FIG. 11, a layout of the RF circuit may include a mixer 310, a routing line 320, an impedance tuner circuit 330, a matching network 340, an amplifier input line 350, and an amplifier 360. An output terminal of the mixer 310 is connected to the impedance tuner circuit 330 through the routing line 320, and the impedance tuner circuit 330 may be connected to the matching network 340. When multiple mixers 310 are provided, the routing line 320 may be configured to combine the outputs of multiple mixers 310 to provide a composite output that may be transferred to the impedance tuner circuit 330.

The matching network 340 may be connected to an input terminal of the amplifier 360 through the amplifier input line 350. As described above, the matching network 340 may be implemented based on an LC tank or a transformer, and may include at least one inductor and at least one capacitor depending on the implementation.

The impedance tuner circuit 330 provided between the routing line 320 and the matching network 340 may be configured to be turned on/off to adjust the load impedance and conversion gain of the mixer 310 according to some embodiments described above.

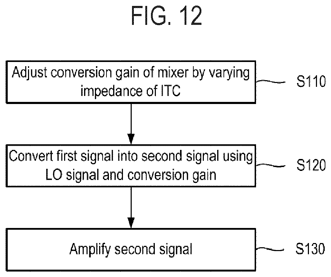

FIG. 12 is a flowchart illustrating a method of operating an RF circuit according to some embodiments.

Referring to FIG. 12, in operation S110, the RF circuit may adjust the conversion gain of the mixer by varying the impedance of the impedance tuner circuit. For example, the conversion gain of the mixer may increase when the impedance tuner circuit is turned off. In operation S120, the RF circuit may convert the first signal into the second signal using the LO signal and the conversion gain adjusted in operation S110. The second signal converted through the mixer may have an amplitude corresponding to the adjusted conversion gain. In operation S130, the RF circuit may amplify the second signal.

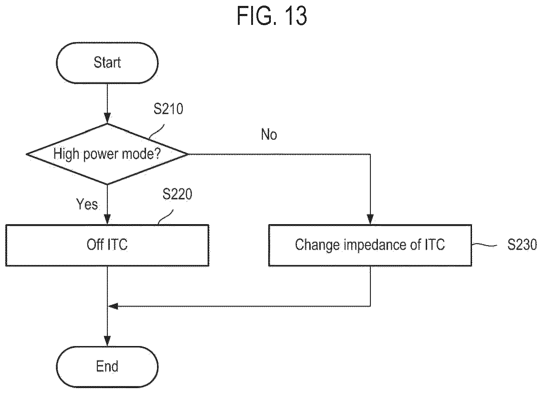

FIG. 13 is a flowchart illustrating a method for adjusting an impedance of an RF circuit, according to some embodiments.

Referring to FIG. 13, in operation S210, the RF circuit may determine whether to operate in the high power mode. For example, an RF circuit may determine whether to operate in a high power mode or a low power mode based on the gain index. For example, the RF circuit may determine the operation as the high power mode when the output power according to the gain corresponding to the gain index is greater than or equal to a first threshold, and may determine the operation as the low power mode when the output power is less than or equal to a second threshold. The first and second thresholds may be the same in some embodiments, and may be different in other embodiments.

When the operation is determined as the high power mode, in operation S220, the RF circuit may turn off the impedance tuner circuit. When the impedance tuner circuit is turned off, the load impedance of the mixer may increase or be optimized, thereby maximizing the conversion gain of the mixer.

Alternatively, the operation is determined as the low power mode, in operation S230, the RF circuit may change the impedance by turning on the impedance tuner circuit. As the impedance of the impedance tuner circuit changes in a lower direction, the load impedance of the mixer will also be lowered (or may be changed to cause a mismatch), so the conversion gain of the mixer will decrease.

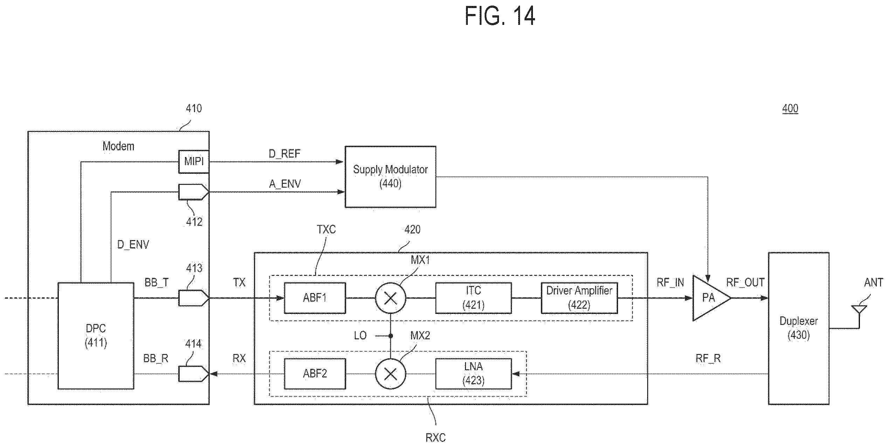

FIG. 14 illustrates a wireless communication device according to some embodiments.

Referring to FIG. 14, a wireless communication device 400 may include a MODEM 410, an RF integrated circuit (RFIC) 420, a power amplifier PA, a duplexer 430, a supply modulator 440, and an antenna ANT.

The MODEM 410 may include a digital processing circuit 411, a first Digital to Analog Converter (DAC) 412, a second DAC 413, an Analog to Digital Converter (ADC) 414, and a Mobile Industry Processor Interface (MIPI). The MODEM 410 may process a baseband signal BB_T (e.g., including an I signal and a Q signal) containing information to be transmitted through the digital processing circuit 411 according to various communication methods. The MODEM 410 may process received baseband signal BB_R through the digital processing circuit 411 according to various communication methods.

For example, the MODEM 410 may process a signal to be transmitted or a received signal in compliance with a communication scheme such as OFDM (Orthogonal Frequency Division Multiplexing), OFDMA (Orthogonal Frequency Division Multiple Access), WCDMA (Wideband Code Multiple Access), or HSPA+ (High Speed Packet Access+). In addition, the MODEM 410 may process the baseband signal BB_T or BB_R in compliance with various types of communication methods (i.e., various communication methods in which technology for modulating or demodulating the amplitude and frequency of the baseband signal BB_T or BB_R is applied).

According to some embodiments, the MODEM 410 may extract an envelope of the baseband signal BB_T through the digital processing circuit 411 and may generate a digital envelope signal D_ENV based on the extracted envelope.

According to some embodiments, the modem 410 may generate an average power signal D_REF based on an average power tracking (APT) table stored in a memory. The APT table may store information of a necessary power supply voltage of the power amplifier PA according to an expected output power (or a transmission power) of the antenna ANT and may store information of an average power signal D_REF corresponding to the necessary power supply voltage of the power amplifier PA. Accordingly, when the expected output power of the antenna ANT is determined, the MODEM 410 may generate the average power signal D_REF by using the APT table and may provide the generated average power signal D_REF to the supply modulator 440 as a reference voltage signal.

The digital processing circuit 411 may perform various processing operations on baseband signals in a digital domain.

For example, the digital processing circuit 411 may perform the above-described average power signal generation, an envelope extraction operation, a digital envelope signal generation, a Crest Factor Reduction (CFR), a Shaping Function (SF), a Digital Pre-Distortion (DPD), a delay correction operation, etc.

The CFR may reduce a peak-to-average power ratio (PAPR) of a communication signal (e.g., the baseband signal BB_T). The SF may transform the digital envelope signal D_ENV to improve the efficiency and linearity of the power amplifier PA. The DPD may linearize the distortion of the power amplifier PA by compensating for the distortion in the digital domain. In addition, the delay correction operation may correct the delay of the digital envelope signal D_ENV or the baseband signal BB_T.

The digital processing circuit 411 may output the digital envelope signal D_ENV and the baseband signal BB_T. In addition, the digital envelope signal D_ENV may be converted into an analog envelope signal A_ENV through the first digital-to-analog converter 412, to be provided to the supply modulator 440, and the baseband signal BB_T may be converted into a transmit signal TX through the second DAC 413 so as to be provided to a transmission circuit TXC.

Although not illustrated in drawings, the digital processing circuit unit 411 may further include an internal component to process the above operations (i.e., baseband signal processing, envelope extraction, and digital envelope signal generation).

The second DAC 413 and the ADC 414 may be provided in numbers of one or more. The MODEM 410 may convert the baseband signal BB_T into an analog signal using the second DAC 413 to generate the transmission signal TX. Additionally, the MODEM 410 may receive a reception signal RX being an analog signal from the RFIC 420. In addition, the MODEM 410 may digitally convert the reception signal RX through the ADC 414 provided therein and may extract the baseband signal BB_R, which is a digital signal. For example, the reception signal RX may be differential signals including a positive signal and a negative signal.

The RFIC 420 may generate an RF input signal RF_IN by performing frequency up-conversion on the transmission signal TX or may generate the reception signal RX by performing frequency down-conversion on an RF reception signal RF_R. For this, the RFIC 420 may include the transmission circuit TXC for frequency up-conversion, a reception circuit RXC for frequency down-conversion, and a local oscillator LO.

In this case, the transmission circuit TXC may include a first analog baseband filter ABF1, a first mixer MX1, an impedance tuner circuit 421, and a driver amplifier 422. For example, the first analog baseband filter ABF1 may include a low pass filter.

The first analog baseband filter ABF1 may filter the transmission signal TX received from the MODEM 410 and may provide the filtered signal to the first mixer MX1. Here, the first analog baseband filter ABF1 may filter the baseband signal. In addition, the first mixer MX1 may perform frequency up-conversion to convert the frequency of the transmission signal TX from the baseband to a high frequency band using the frequency signal provided by the local oscillator LO. In this case, the first mixer MX1 may be the mixer illustrated in FIGS. 1 to 3 and 6 to 8 described above. Through this frequency up-conversion, the transmission signal TX may be provided to the driver amplifier 422 as the RF input signal RF_IN, and the driver amplifier 422 may first amplify the power of the RF input signal RF_IN to provide the amplified result to the power amplifier PA.

According to some embodiments, the impedance tuner circuit 421 may be provided between the first mixer MX1 and the driver amplifier 422. The impedance tuner circuit 421 may be the same as the impedance tuner circuit 120 or 220 illustrated in FIGS. 1 to 3 and 6 to 8 described above. The impedance tuner circuit 421 may be configured to adjust the conversion gain of the first mixer MX1 by varying its impedance.

For example, the impedance tuner circuit 421 may be turned off when the power amplifier PA operates in a high power mode in which its output power is greater than or equal to a first threshold. The conversion gain may be maximized when the impedance tuner circuit 421 is turned off.

For example, the impedance tuner circuit 421 may be turned on based on the power amplifier PA operates in a low power mode in which its output power is less than equal to a second threshold. As the impedance of the impedance tuner circuit 421 changes in a lower direction, the conversion gain of the first mixer MX1 will also decrease. As the conversion gain is adjusted through the impedance tuner circuit 421, the power of the output signal of the first mixer MX1 will also change. Here, when the impedance of the impedance tuner circuit 421 is lowered, the conversion gain will decrease, so the output signal of the first mixer MX1 may have lower power. Accordingly, control of the conversion gain of the first mixer MX1 through the impedance tuner circuit 421 may contribute to reducing the size of the leakage component of the driver amplifier 422.

The power amplifier PA may be supplied with DC voltage or a variable power supply voltage (i.e., a dynamically variable output voltage), and may secondarily amplify the power of the RF input signal RF_IN based on the supplied power supply voltage to generate an RF output signal RF_OUT. In addition, the power amplifier PA may provide the generated RF output signal RF_OUT to the duplexer 430.

According to some embodiments described above, depending on whether the output power required for the power amplifier PA is high power or low power, the load impedance of the mixer MX1 may be adjusted through the impedance tuner circuit 421 provided at the front end of the power amplifier PA. The conversion gain of the first mixer MX1 is adjusted according to the load impedance control, and a lower level input signal may be applied to the driver amplifier 422 through the conversion gain control, especially in the low power mode. Accordingly, the driver amplifier 422 may expand the dynamic range by outputting a lower leakage component. Ultimately, the dynamic range of the transmission chain, including the transmission circuit TXC and the power amplifier PA, may be improved.

The reception circuit RXC may include a second analog baseband filter ABF2, a second mixer MX2, and a low-noise amplifier (LNA) 423. For example, the second analog baseband filter ABF2 may include a low pass filter.

The LNA 423 may amplify the RF reception signal RF_R provided from the duplexer 430, which is then provided to the second mixer MX2. In addition, the second mixer MX2 may perform frequency down-conversion to convert the frequency of the reception signal RF_R from the high frequency band to the baseband using the frequency signal provided by the local oscillator LO. Through this frequency down-conversion, the RF reception signal RF_R may be provided as the reception signal RX to the second analog baseband filter ABF2, and the second analog baseband filter ABF2 may filter the reception signal RX which is then provided to the MODEM 410.

In an embodiment, the wireless communication device 400 may transmit a transmit signal through a plurality of frequency bands by using a carrier aggregation (CA). In addition, for this purpose, the wireless communication device 400 may include a plurality of power amplifiers PA that amplify power of a plurality of RF input signals RF_IN respectively corresponding to a plurality of carrier waves. However, in this discussion, for convenience of description, the description will be given as the number of power amplifiers is "1".

The duplexer 430 may be connected with the antenna ANT and may separate a transmission frequency from a reception frequency. In detail, the duplexer 430 may separate the RF output signal RF_OUT provided from the power amplifier PA for each frequency band so as to be provided to the corresponding antenna ANT. Also, the duplexer 430 may provide an external signal provided from the antenna ANT to an LNA included in an RF circuit 423 of the reception circuit RXC of the RFIC 420. For example, the duplexer 430 may include a front end module with integrated duplexer (FEMiD).

In an embodiment, the wireless communication device 400 may include a switch structure capable of separating the transmission frequency and the reception frequency instead of the duplexer 430. Also, the wireless communication device 400 may include a structure implemented with the duplexer 430 and a switch for the purpose of separating the transmission frequency and the reception frequency. However, for convenience of description, an embodiment of the present disclosure will be described to include the duplexer 430 capable of separating the transmission frequency and the reception frequency is included in the wireless communication device 400.

The supply modulator 440 may generate a modulated output voltage, the level of which varies dynamically, based on the analog envelope signal A_ENV and the average power signal D_REF and may provide the modulated output voltage to the power amplifier PA as a power supply voltage.

In detail, the supply modulator 440 may be provided with the average power signal D_REF and the analog envelope signal A_ENV from the modem 410. The supply modulator 440 may be driven in the tracking mode corresponding to one of the ET mode and the APT mode based on the average power signal D_REF and the analog envelope signal A_ENV thus provided and may generate the dynamically variable output voltage. Also, the supply modulator 440 may supply the generated output voltage to the power amplifier PA as the power supply voltage.

For instance, when the power supply voltage of a fixed level is applied to the power amplifier PA, power efficiency of the power amplifier PA may be reduced. Accordingly, to efficiently manage a power of the power amplifier PA, the supply modulator 440 may modulate an input voltage (i.e., a power provided from a battery) based on at least one of the analog envelope signal A_ENV and the average power signal D_REF and may provide the modulated voltage to the power amplifier PA as the power supply voltage.

The antenna ANT may transmit an RF output signal RF_OUT frequency-separated by the duplexer 430 to the outside or provide an RF reception signal RF_R received from the outside to the duplexer 430. For example, the antenna ANT may include, but is not limited to, an array antenna.

For reference, each of the MODEM 410, the RFIC 420, the power amplifier PA, the duplexer 430, and the supply modulator 440 may be individually implemented with an integrated circuit, a chip, or a module. Also, the MODEM 410, the RFIC 420, the power amplifier PA, the duplexer 430, and the supply modulator 440 may be together mounted on a printed circuit board (PCB). However, the technical idea of the present disclosure is not limited thereto, in some embodiments, at least a part of the MODEM 410, the RFIC 420, the power amplifier PA, the duplexer 430, and the supply modulator 440 may be implemented with a single communication chip.

In addition, the wireless communication device 400 illustrated in FIG. 14 may be included in a wireless communication system that uses a cellular network such as 5G, LTE and may also be included in a wireless local area network (WLAN) system or any other wireless communication system. In an embodiment, a configuration of the wireless communication device 400 illustrated in FIG. 14 is, but is not limited to, an embodiment by way of example, and may be variously configured in compliance with a communication protocol or a communication scheme.

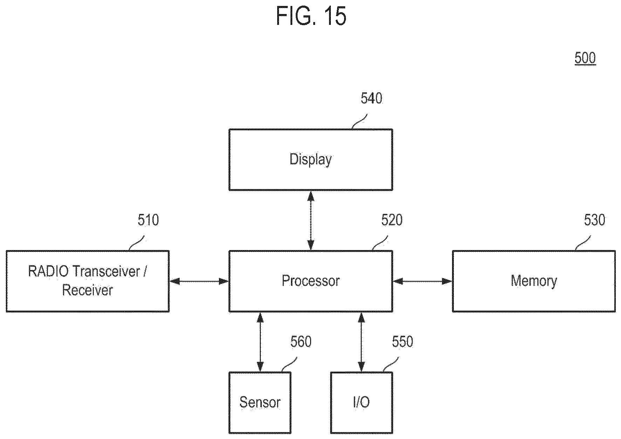

FIG. 15 illustrates an IoT (Internet of Things) device to which a wireless communication device is applied, according to some embodiments.

Referring to FIG. 15, an IoT may mean a network between things that use wired and/or wireless communication. The IOT device may include an accessible wired or/and wireless interface and may include devices that communicate with one or more other devices through the wired or/and wireless interface to transmit or receive data. The accessible interface that the IoT product includes may include a modem communication interface that is accessible to a local area network (LAN), a wireless local area network (WLAN) such as a wireless fidelity (Wi-Fi), a wireless personal area network (WPAN) such as Bluetooth, a wireless universal serial bus (USB), a Zigbee, a near field communication (NFC), a radio-frequency identification (RFID), a power line communication (PLC), or mobile cellular networks such as 3rd generation (3G), long term evolution (LTE), 4th generation (4G), or 5th generation (5G). The Bluetooth interface may support Bluetooth low energy (BLE).

In detail, an IOT device 500 may include a communication interface 510 (RADIO transceiver/receiver) for communicating with the outside. The communication interface 510 may be, for example, a modem communication interface that is accessible to a wireless local area network such as an LAN, Bluetooth, Wi-Fi, or Zeebee, PLC, a mobile communication network, such as 3G, LTE, 4G, or 5G, etc. The communication interface 510 may include a transceiver and/or a receiver. The IOT device 500 may transmit and/or receive information from an access point or a gateway through the transceiver and/or the receiver. Also, the IOT device 500 may communicate with a user apparatus or any other IOT device to transmit and/or receive control information or data of the IOT device 500.

The wireless communication device 400 described above with reference to FIG. 14 may be implemented in the communication interface 510, and accordingly, at least one of the supply modulator 440 described above with reference to FIG. 14 may be implemented in a transmission unit of the communication interface 510.

The IOT device 500 may further include a processor or application processor (AP) 520 performing calculation. For internal power supply, the IOT device 500 may further include an embedded battery or a power supply unit that is supplied with power from an external source. Also, the IOT device 500 may include a display 540 for displaying an internal state or data. The user may control the IOT device 500 through a user interface (UI) of the display 540 in the IOT device 500. The IOT device 500 may transmit an internal state and/or data to the outside through the transceiver and may receive a control instruction and/or data to the outside through the receiver.

A memory 530 may store a control instruction code controlling the IOT device 500, control data, or user data. The memory 530 may include at least one of a volatile memory or a nonvolatile memory. The nonvolatile memory includes at least one of various memories such as a read only memory (ROM), a programmable ROM (PROM), an electrically programmable ROM (EPROM), an electrically erasable and programmable ROM (EEPROM), a flash memory, a phase-change RAM (PRAM), a magnetic RAM (MRAM), a resistive RAM (ReAM), and a ferroelectric RAM (FRAM). The volatile memory may include at least one of various memories such as a static RAM (SRAM), a dynamic RAM (DRAM), and a synchronous DRAM (SDRAM).

The IOT device 500 may further include a storage device. The storage device may include at least one of nonvolatile media such as a solid state drive (SSD), an embedded multimedia card (eMMC), and universal flash storage (UFS). The storage device may store user information provided through an input/output unit (I/O) 550 and pieces of sensing information collected through a sensor 560.

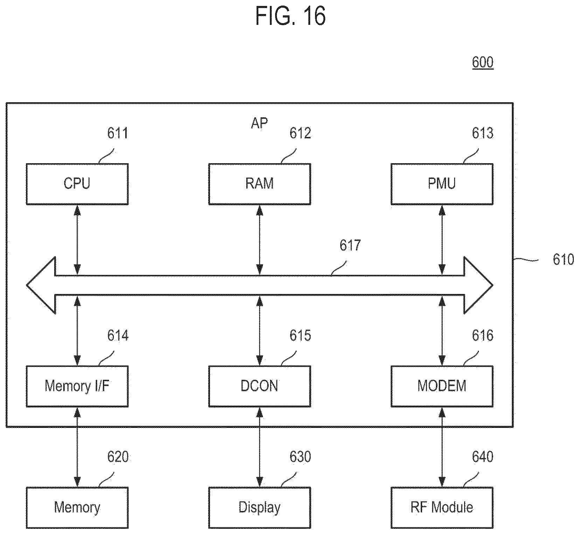

FIG. 16 illustrates a mobile terminal to which a wireless communication device is applied, according to some embodiments.

Referring to FIG. 16, a mobile terminal 600 may include an application processor (hereinafter referred to as an "AP") 610, a memory 620, a display 630, and an RF module 640. In addition, the mobile terminal 600 may further include various components such as a lens and an audio module.

The AP 610 may be implemented with a system on chip (SoC) and may include a central processing unit (CPU) 611, a RAM 612, a power management unit (PMU) 613, a memory interface (I/F) 614, a display controller (DCON) 615, a MODEM 616, and a system bus 617. In addition, the AP 610 may further include various intellectual properties. The AP 610 may be integrated with a function of a MODEM chip therein, which is referred to as a "ModAP".

The CPU 611 may control overall operations of the AP 610 and the mobile terminal 600. The CPU 611 may control an operation of each component of the AP 610. Also, the CPU 611 may be implemented with a multi-core. The multi-core may be one computing component having two or more independent cores.

The RAM 612 may temporarily store programs, data, or instructions. For example, the programs and/or data stored in the memory 620 may be temporarily stored in the RAM 612 under control of the CPU 611 or depending on a booting code. The RAM 612 may be implemented with a DRAM or an SRAM.

The PMU 613 may manage power of each component of the AP 610. The PMU 613 may also determine an operating situation of each component of the AP 610 and may control an operation thereof.

The memory interface 614 may control overall operations of the memory 620 and may control data exchange of the memory 620 with each component of the AP 610. Depending on a request of the CPU 611, the memory interface 614 may write data in the memory 620 or may read data from the memory 620.

The display controller 615 may provide the display 630 with image data to be displayed on the display 630. The display 630 may be implemented with a flat panel display, such as a liquid crystal display (LCD) or an organic light emitting diode (OLED) display, or a flexible display.

For wireless communication, the MODEM 616 may modulate data to be transmitted in a suitable manner for a wireless environment and may recover received data. The MODEM 616 may perform digital communication with the RF module 640.

For reference, the MODEM 616 may be implemented with the MODEM 410 described above with reference to FIG. 14.

The RF module 640 may convert a high-frequency signal received through an antenna into a low-frequency signal and may transmit the converted low-frequency signal to the MODEM 616. Also, the RF module 640 may convert a low-frequency signal received from the MODEM 616 into a high-frequency signal and may transmit the converted high-frequency signal to free space through the antenna. Also, the RF module 640 may amplify or filter a signal.

For example, in this RF module 640, the RFIC 420, the power amplifier PA, the duplexer 430, the supply modulator 440, and the antenna ANT described above with reference to FIG. 14 may be implemented.

For this reason, in the mobile terminal 600, wide band communication may be possible, and power consumption for communication may be reduced.

According to an embodiment of the present disclosure, an RF circuit capable of controlling the conversion gain of a mixer and a method of operating the same may be provided.

The above descriptions are specific embodiments for carrying out the present disclosure. While the present disclosure has been described with reference to embodiments thereof, it will be apparent to those of ordinary skill in the art that various changes and modifications may be made thereto without departing from the scope of the present disclosure as set forth in the following claims.

## Claims

1. A radio frequency, RF, circuit comprising:
a mixer (110; 210; 310; MX1) configured to convert a first signal (S1) into a second signal (S2) using a local oscillator, LO, signal (LO);
an amplifier (140; 240; 360; 422) configured to amplify the second signal (S2); and
an impedance tuner circuit (120; 220; 330; 421) connected between the mixer (110; 210; 310; MX1) and an input terminal of the amplifier (140; 240; 360; 422) and configured to adjust a conversion gain of the mixer (110; 210; 310; MX1) by presenting a variable impedance.

2. The RF circuit of claim 1, further comprising:
a matching network (130; 230; 340) connected between the impedance tuner circuit (120; 220; 330) and the input terminal of the amplifier (140; 240; 360) and configured to match an impedance between the mixer (110; 210; 310) and the amplifier (140; 240; 422).

3. The RF circuit of claim 1 or 2, wherein the impedance tuner circuit (120; 220; 330; 421) is controlled to have an impedance that varies based on an output power of the RF circuit (100; 200; 300; 420).

4. The RF circuit of claim 3, wherein the impedance tuner circuit (120;
220; 330; 421) is turned off when the RF circuit (100; 200; 300; 420) operates in a high power mode in which the output power of the RF circuit (100; 200; 300; 420) is greater than or equal to a first threshold.

5. The RF circuit of claim 3 or 4, wherein the impedance tuner circuit (120; 220; 330; 421) is turned on when the RF circuit (100; 200; 300; 420) operates in a low power mode in which the output power of the RF circuit (100; 200; 300; 420) is less than or equal to a second threshold.

6. The RF circuit of claim 4 or 5, wherein the conversion gain is maximized when the impedance tuner circuit (120; 220; 330; 421) is turned off.

7. The RF circuit of any one of claims 1 to 6, wherein the impedance tuner circuit (120; 220; 330; 421) includes one or more variable impedance circuits (VZ; VZ1-VZn).

8. The RF circuit of claim 7, wherein the impedance tuner circuit (120; 220; 330; 421) is configured to stepwise adjust the conversion gain by varying the one or more variable impedance circuits (VZ; VZ1-VZn) in a corresponding stepwise manner.

9. The RF circuit of any one of claims 1 to 8, further comprising:
a logic circuit (250) configured to vary the impedance of the impedance tuner circuit (220) based on a gain index for a gain control of the RF circuit (200).

10. The RF circuit of claim 9, wherein the logic circuit (250) turns on the impedance tuner circuit (220) at a k-th value of the gain index to decrease the conversion gain, where 'k' is a natural number.

11. The RF circuit of claim 10, wherein the amplifier (240) amplifies the second signal (S2) with an amplifier gain adjusted to compensate for the decrease of the conversion gain.

12. The RF circuit of claim 10 or 11, wherein, when amplifying the second signal (S2), the amplifier (240) outputs a leakage component that decreases as the conversion gain decreases.

13. The RF circuit of any one of claims 1 to 12, wherein the mixer (110; 210; 310; MX1) is implemented as a passive mixer.

14. A wireless communication device comprising:
the radio frequency, RF, circuit according to any one of claims 1 to 13, wherein the first signal is a baseband signal, the second signal is an RF signal, and the RF circuit is an RF integrated circuit, RFIC, (420) configured to up-convert the baseband signal to output the RF signal; and
a power amplifier (PA) configured to amplify the RF signal

15. The wireless communication device of claim 14, wherein the impedance tuner circuit (120; 220; 330; 421) is turned off when the power amplifier (PA) operates in a high power mode in which the output power of the power amplifier (PA) is greater than or equal to a first threshold, and is turned on when the power amplifier (PA) operates in a low power mode in which the output power is less than or equal to a second threshold.
